# EUROPEAN PATENT SPECIFICATION

(11) **EP 4 328 972 B1**
(45) Date of publication and mention of the grant of the patent: **21.10.2026**
(21) Application number: 22792014.7
(22) Date of filing: 19.04.2022
(51) Int. Cl.: H10W 44/00, H04N 23/57, H04N 23/54, H10W 90/00

(54) **SIP MODULE**
SIP-MODUL
MODULE SIP

(30) Priority: 21.04.2021 KR 20210051972
(43) Date of publication of application: 28.02.2024
(73) Proprietor: LG Innotek Co., Ltd., Seoul 07796 (KR)
(72) Inventor: CHOI, Byung Hyun, Seoul 07796 (KR)
(74) Representative: DREISS Patentanwälte PartG mbB
(86) International application number: PCT/KR2022/005628
(87) International publication number: WO 2022/225314

(56) References cited:
- CN-U- 203 970 339
- JP-A- 2008 305 937
- JP-A- 2010 093 214
- KR-A- 20110 068 796
- KR-A- 20120 031 817
- KR-A- 20120 031 817
- KR-A- 20170 132 495
- KR-B1- 101 602 706
- US-A1- 2016 198 095
- US-A1- 2017 127 921

## Description

### [Technical Field]

The present invention relates to a SiP module, and more particularly, to a technology in which a serializer is embedded in a SiP module substrate.

### [Background Art]

KR 2017 0132495 A discloses a SiP module according to the preamble of claim 1.

KR20120031817 discloses a circuit board having a semiconductor chip and stacked semiconductor package. A cavity is formed on one surface of a first substrate. A semiconductor chip with terminals is arranged in the cavity to electrically connect to the first substrate. The other surface of the semiconductor chip is exposed outside the first substrate. A second substrate is laminated on the other surface of the first substrate. US20160198095 discloses an image sensor module including a printed circuit board. An image sensor chip is disposed on a first plane of the printed circuit board. US20170127921 discloses an imaging unit including a semiconductor package having an image sensor and connection electrodes on its back side. CN203970339 discloses a miniature imaging module for an endoscope using PCB connections.

Advanced driver assistance system (ADAS) is one of the most rapidly growing fields among automotive applications. Owing to various functions, in addition to warning the driver and ensuring better visibility in the outside of the vehicle, parking assistance and adaptive cruise control and the like are also supported. These functions are realized by various measurement systems based on radar, camera, distance measurement using light, ultrasonic waves, and the like.

Implementation of the ADAS function using a camera may be performed by processing an image acquired from the camera. Accordingly, miniaturization of the camera module is required.

### [Detailed Description of the Invention]

### [Technical Subject]

A technical subject to be solved by the present invention is to provide a system in package (SiP) module capable of simplifying an interface by modularizing an image sensor and a serializer that have been separated in the prior art.

The subjects of the present invention are not limited to the subjects mentioned above, and other subjects not mentioned will be clearly understood by those skilled in the art from the following description.

### [Technical Solution]

The invention is as defined in claim 1.

The serializer may be any one among a low voltage differential signaling (LVDS), V-by-One HS, HD-Base-T, and MIPI A-PHY chip sets.

The image sensor is one image sensor among plurality types of image sensors, and a pin may be formed at a position corresponding to a connecting terminal configured with one pin map on one surface of the substrate.

A camera module according to the present embodiment may comprise: a first substrate; an image sensor being disposed on one surface of the first substrate; a serializer being embedded inside the substrate; and a second substrate being disposed with the first substrate on one surface thereof, wherein the first substrate may include a via hole penetrating the first substrate in order to electrically connect the image sensor and the serializer.

A power block and a connector may be disposed on the other surface of the second substrate.

### [Advantageous Effects]

According to the present embodiment, the internal structure of the camera can be miniaturized compared to the conventional design by embedding the serializer in substrate, and price competitiveness can be secured through the relaxation of the substrate specifications and the removal of the flexible substrate.

In addition, by modularizing the image sensor and serializer into a SiP module, the overall assembly process can be simplified because a separate image sensor reinforcement process is not required in the final camera assembly process.

In addition, even if the type of image sensor is different, it can be connected to the SiP module substrate configured with the same pin map, so that the SiP module can be transformed into a platform.

Effects according to the present invention are not limited by the contents exemplified above, and more various effects are included in the present specification.

### [Brief Description of Drawings]

FIG. 1 illustrates an internal substrate of a conventional vehicle camera.
FIG. 2 is a block diagram of a camera internal interface according to the present embodiment.
FIGS. 3 to 5 illustrate a SiP module.

### [BEST MODE]

Hereinafter, preferred embodiments of the present invention will be described in detail with reference to the accompanying drawings.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or arranged in "on (above)" or "below (under)" of each component, "on (above)" or "below (under)" means that it includes not only the case where the two components are directly in contact with, but also the case where one or more other components are formed or arranged between the two components. In addition, when expressed as "on (above)" or "below (under)", the meaning of not only an upward direction but also a downward direction based on one component may be included.

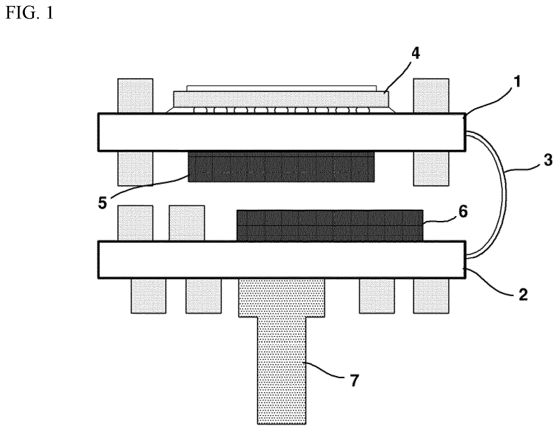

In general, a camera structure for a vehicle includes a serializer for high-speed transmission of video signals because the physical distance between a location where the camera is attached and a host is large. Hereinafter, with reference to FIG. 1, a conventional camera module internal substrate structure will be described.

An image sensor **4** is disposed on an upper surface of an upper substrate **1,** a power block **5** is disposed on a lower surface, a serializer **6** is disposed on an upper surface of a lower substrate **2,** and a connector **7** may be connected to a lower surface. In addition, additional electronic parts may be disposed on the upper substrate 1 and the lower substrate **2** in addition to the above parts. This is exemplary and is not particularly limited thereto.

The upper substrate **1** and the lower substrate **2** may be connected through a flexible substrate **3.** Since the image sensor **4** and the serializer **6** have many signal connections, and the image signal received from the image sensor **4** must be transmitted to the serializer **6** at high speed, the image sensor **4** disposed on different substrates and the serializer **6** are electrically connected through the flexible substrate **3.**

In such an internal structure of the camera module, there is a problem in that as the image sensor becomes highly pixelated, an increased number of connection pads and a high-spec PCB are required, and processes such as additional bonding are increased to enhance reliability due to the miniaturization of the camera.

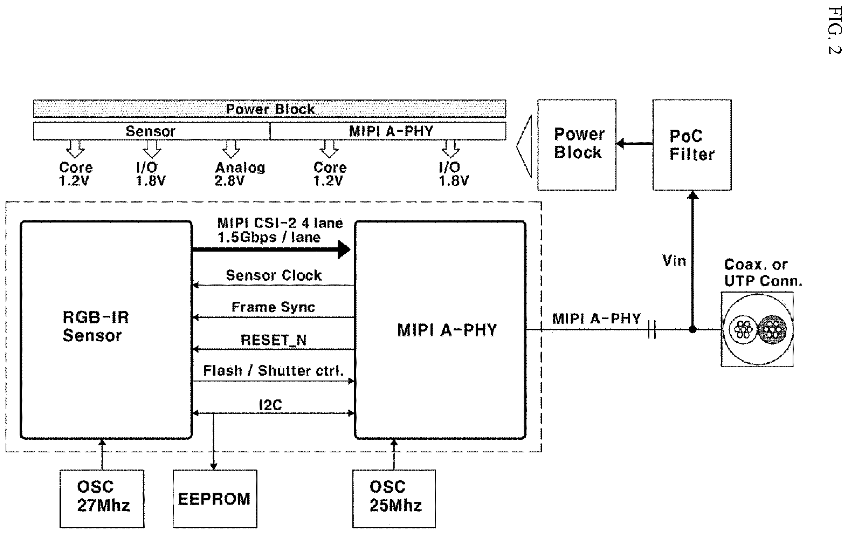

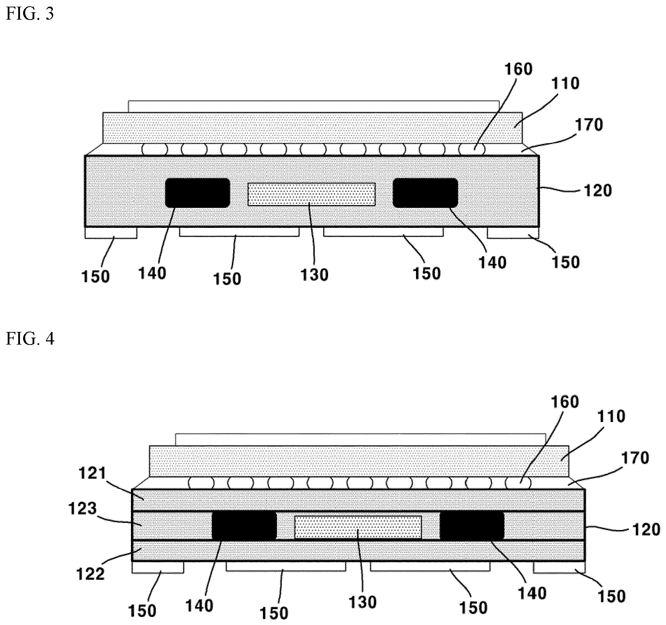

Hereinafter, the SiP module according to the present embodiment will be described with reference to FIGS. 2 to 5. FIG. 2 illustrates a block diagram of a camera internal interface. FIGS. 3 to 5 illustrate a SiP module.

The SiP module substrate according to the present embodiment includes a substrate **120** and a serializer **130,** and the SiP module includes an image sensor **110,** a substrate **120,** and a serializer **130.**

The substrate **120** may be a printed circuit board (PCB). In an embodiment, which is not according to the present invention and which is presented for illustration purpose only, the substrate **120** may be formed of a single layer. The substrate **120** may be formed of a plurality of layers.

An embedded serializer **130** is included in the substrate **120.** Unlike conventional bonding of electronic parts on the surface of a substrate through surface mounting technology (SMT), the "embedded technology" used in the present invention refers to a technology of inserting electronic parts into a substrate.

Since the serializer **130** is embedded inside the substrate **120,** the size of the substrate **120** is reduced, and the connection length between other active and passive devices mounted inside the substrate **120** is shortened, so that the electrical performance can be improved by reducing the inductance component and the reliability of surface mounting of the substrate can be improved by reducing the number of soldering works for mounting.

Specifically, the serializer **130** is embedded inside the substrate **120** and electrically connected to the image sensor **110.** Although not shown, via hole (not shown) may be formed in the substrate **120** to electrically connect the image sensor **110** and the serializer **130.** FIG. 3 discloses an embodiment, which is not according to the present invention and which is presented for illustration purpose only. IN this embodiment, the serializer **130** may be disposed to be embedded inside a substrate **120** formed of a single layer.

FIG. 4 refers to the substrate **120,** which is formed of a plurality of layers. The serializer **130** is disposed between the pluralities of layers. The substrate **120** includes first to third layers **121, 122,** and **123,** and it is natural that the number of layers may be increased or decreased according to the number of parts to be mounted, and is not particularly limited thereto. The image sensor **110** is disposed on an upper surface of the first layer **121,** which is the top layer of the substrate **120.** A heat dissipation pad **150** is disposed on a lower surface of the third layer **122,** which is a bottom layer of the substrate **120.** The serializer **130** is disposed in the second layer **123** positioned between the first layer **121** and the third layer **122.** Although not shown, a plurality of electronic elements may be disposed on an upper surface of the first layer **121** or a lower surface of the third layer **122.**

An adhesive member is applied on one surface of a layer on which the serializer **130** is disposed among the pluralities of layers of the substrate **120.** The adhesive member may be epoxy. This is to zero the air in the layer of the substrate **120** in which the serializer **130** is embedded so that thermal expansion does not occur. Among the plurality of layers of the substrate **120,** a layer on which the serializer **130** is disposed is molded so that the serializer **130** is embedded therein.

A serializer, also referred to as a serial converter, is a configuration that converts various parallel signals into serial signals. Specifically, the serializer receives parallel data from a large number of pins, converts it into serial data, and outputs the data through a small number of pins, thereby possibly reducing the overall number of pins by allowing one pin to play multiple roles.

The serializer **130** may be any one among a low voltage differential signaling (LVDS), V-by-One HS, HD-Base-T, and MIPI A-PHY chip sets. The serializer **130** may be any one among a variety of communication interfaces. The serializer **130** may be in the form of a chip. The serializer **130** may be in the form of an element. The serializer **130** may be in the form of an electronic part.

Mobile industry processor interface (MIPI) is an interface specification defined by the MIPI Alliance established by Intel, ARM, Nokia, Samsung, ST, and TI to enhance reuse and compatibility in mobile and Internet of Things devices. The specifications set by MIPI include MIPI D-PHY, MIPI M-PHY, MIPI C-PHY, and the like. In particular, MIPI A-PHY can be used when data is transmitted at high speed between cameras and displays, and a related domain electronic control units (ECUs). MIPI A-PHY has high stability with low error rate, has high resilience with ultra-high level of tolerance even in automotive environment, can be used in long-distance communication range, and can improve data rate.

Referring to FIG. 2, RGB-IR Sensor, which is the image sensor **110,** and MIPI A-PHY, which is one type of the serializer **130,** communicates through a plurality of pins. Conventionally, the image sensor and the serializer are disposed in separate substrates, requiring a flexible substrate to connect each substrate. However, the SiP module according to the present embodiment disposes the image sensor on an upper surface of the substrate and the serializer is embedded inside the substrate, and the image sensor and serializer are electrically connected and modularized.

A resistor **140** being embedded inside the substrate **120** is included.

Specifically, the resistor **140** may be connected to electronic parts being disposed inside the substrate **120.** Electronic parts being mounted inside or on a surface of the substrate **120** are connected to the resistor **140** being embedded inside the substrate **120** so that they are terminated inside the substrate **120.**

Through this, it is possible to simplify the inside of the substrate **120** without the need to connect the electronic parts to the outside through wires.

The resistor **140** is disposed adjacent to the serializer **130** being embedded in the substrate **120.** The resistor **140** may include a plurality of resistors. When the substrate **120** is formed of a plurality of layers, the resistor **140** is embedded in a layer in which the serializer **130** is embedded.

An image sensor **110** may be disposed on an upper surface of the substrate **120.**

Specifically, the image sensor **110** may be electrically connected to the substrate **120.** The image sensor **110** may be electrically connected to the serializer **130** embedded in the substrate **120.** The image sensor may be coupled to the substrate **120** by surface mounting technology. The image sensor may be coupled to the substrate **120** by flip chip technology.

The image sensor **110** may be any one among a charge coupled device (CCD), a complementary metal oxide semiconductor (CMOS), a CPD, and a CID. The horizontal and/or vertical length of a unit pixel of the image sensor **110** may be 2 µm (micrometer) or less. It is not particularly limited thereto, and the overall size of the image sensor **110** may be increased as the number of pixels increases. Through this, it can be applied to a camera module with a high number of pixels and/or pixels.

Referring to FIG. 3, the image sensor **110** may be coupled to the substrate **120** using flip chip technology. Flip-chip technology is a method of wireless bonding, one of device mounting technologies, and is a technology to fuse as it is using lead bumps that serve as electrodes on the bottom side without using an additional connection structure such as a metal lead (wire) or an intermediate medium such as a ball grid array (BGA) when attaching a chip to a substrate. This technology has effects in that it is advantageous in miniaturization and light weight as the package is the same size as the chip, has excellent thermal stability and high current application rate, can increase the reaction speed, and can make the distance between electrodes much finer.

A bump **160** is formed on a lower surface of the image sensor **110** and can be bonded to the substrate **120** by fusion bonding. The bump **160** is bonded to the substrate **120** by compression or may be bonded by thermal compression. After the bump **160** of the image sensor **110** is fused to and coupled to an upper surface of the substrate **120,** an adhesive member **170** may be additionally applied between the image sensor **110** and an upper surface of the substrate **120.** An underfill may be applied between the image sensor **110** and an upper surface of the substrate **120.** A certain space formed between the image sensor **110** and the substrate **120** can be filled by the bump **160** of the image sensor **110,** and the mounting reliability of the image sensor **110** can be reinforced.

The substrate **120** may include at least one via hole penetrating the substrate **120.** The serializer **130** may be electrically connected to the image sensor **110** being disposed in the substrate **120** through via hole. The resistor **140** and electronic parts may be electrically connected to each other through via holes.

The image sensor **110** may be one among a plurality of types of image sensors. For example, the type and size of the image sensor **110** may vary depending on the number of pixels. In general, as the area of the image sensor increases, a sharper resolution image can be obtained.

A pin may be formed on one surface of the substrate **120** at a position corresponding to a connection terminal configured with one pin map. It is possible to couple different image sensors by replacing them in the connection terminal configured with one pin map, and there is no need to separately manufacture a SiP module substrate for each type of image sensor. The SiP module for each pixel of the image sensor is configured with the same size and the same pin map so that the substrate of the camera module can be made into a platform.

A heat dissipation pad **150** is disposed on the other surface of the substrate **120.**

Specifically, the heat dissipation pad **150** may be a thermal conductive tape (thermal pad). The heat dissipation pad **150** has high thermal conductivity and can reduce heat generated inside the camera. The heat dissipation pad **150** may be in the form of a tape. The heat dissipation pad **150** may be in the form of a double-sided tape.

The serializer **130** is disposed to be overlapped with the heat dissipation pad **150** in an optical axis direction. The serializer **130** is disposed to be overlapped with the heat dissipation pad **150** in a direction perpendicular to the optical axis. Through this, heat being radiated from the serializer **130** can be more effectively discharged.

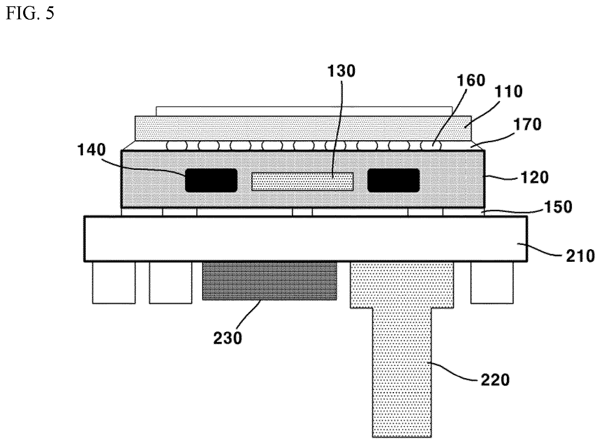

Next, referring to FIG. 5, the camera module including a SiP module according to the present embodiment will be described. The SiP module according to the present embodiment includes an image sensor **110,** a first substrate **120,** and a serializer **130,** and a camera module according to the present embodiment may include an image sensor **110** and a first substrate **120,** a serializer **130,** and a second substrate **210.** The detailed description of the camera module of the present invention corresponds to the detailed description of each part with reference to FIGS. 2 and 3, so overlapping descriptions will be omitted.

One surface of the second substrate **210** may be disposed on the first substrate **120** of the SiP module, and the power block **230** and the connector **220** may be disposed on the other surface of the second substrate **210.** The first substrate **120** may be coupled to an upper surface of the second substrate **210** by the heat dissipation pad **150** being disposed on a lower surface of the first substrate **120.** This is exemplary and is not particularly limited thereto.

The power block **230** may be coupled to the second substrate **210.** The power block **230** may be a converter. The power block **230** may convert a level of power received from an external device (not shown) into a level of power required by the substrate, and a power having the converted level can be outputted to each electronic part. For example, the power block **230** may include at least one of a DC-DC converter (not shown) or a low voltage drop out (LDO) regulator (not shown).

The connector **220** may be coupled to the second substrate **210.** The connector **220** may be electrically connected to the second board **210.** The connector **220** may supply external power into the camera device. The connector **220** may include a port for electrical connection with an external device. The cross section of the connector **220** may be formed in a circular shape. Unlike this, the cross section of the connector **220** may be variously changed into an elliptical or rectangular shape and the like.

According to the present embodiment, the internal structure of the camera can be miniaturized compared to the conventional design by embedding the serializer in a substrate, so price competitiveness can be secured through the relaxation of the substrate specifications and the removal of the flexible substrate. In addition, by modularizing the image sensor and serializer SiP, the entire assembly process can be simplified as a separate image sensor reinforcement process is not required in the final camera assembly process. In addition, even if the type of image sensor is different, it can be connected to the SiP module substrate configured with the same pin map, so that the SiP module can be made into a platform.

Although the embodiments of the present invention have been described with reference to the accompanying drawings, those of ordinary skill in the art to which the present invention belongs will be able to understand that the present invention may be embodied in other specific forms.

Therefore, the embodiments described above should be understood as illustrative in all respects and not limiting.

### [Description of the Symbols]

| | | | |
|---|---|---|---|
| 110: | image sensor | 120: | substrate |
| 130: | serializer | 140: | resistor |
| 150: | heat dissipation pad | 160: | solder ball |
| 170: | adhesive member | 210: | camera module substrate |
| 220: | connector | 230: | power block |

## Claims

1. A System in Package, SiP, module, comprising:
a substrate (120);
an image sensor (110) being disposed on one surface of the substrate (120);
a serializer (130) being embedded inside the substrate (120), and
a heat dissipation pad (150) being disposed in other surface of the substrate (120),
wherein the substrate (120) includes a via hole that penetrates through the substrate (120) in order to electrically connect the image sensor (110) and the serializer (130),
wherein the serializer (130) is disposed to be overlapped with the image sensor (110) in an optical axis,
wherein the serializer (130) is disposed to be overlapped with the heat dissipation pad (150) in the optical axis direction,
**characterized in that**
the substrate (120) comprises a first layer (121) being disposed with the image sensor (110), a second layer (123) being embedded with the serializer (130), and a third layer (122) being disposed with the heat dissipation pad (150),
that the second layer (123) is disposed between the first layer (121) and the third layer (122),
that the second layer (123) is molded so that the serializer (130) is embedded therein, and
that a resistor (140) is embedded inside the second layer (123) of the substrate (120) adjacent to the serializer (130), wherein electronic parts being mounted inside or on a surface of the substrate (120) are connected to the resistor (140) so that they can be terminated inside the substrate (120), and
that a first adhesive member is applied to one surface of the second layer (123) to eliminate air in the second layer (123) in which the serializer (130) is embedded so that thermal expansion does not occur.

2. The SiP module according to claim 1, comprising: a bump (160) being formed on a lower surface of the image sensor (110), wherein the bump (160) is bonded to the substrate (120).

3. The SiP module according to claim 2, wherein a second adhesive member (170) is applied to a certain space formed between the image sensor (110) and the substrate (120).

4. The SiP module according to claim 1, wherein the serializer (130) is any one among a low voltage differential signaling (LVDS), V-by-One HS, HD-Base-T, and MIPI A-PHY chip sets

5. The SiP module according to claim 1, wherein the image sensor (110) is one image sensor (110) among a plurality types of image sensors (110), and wherein a pin is formed at a position corresponding to a connecting terminal configured with one pin map on one surface of the substrate (120).

## Patentansprüche

1. System-in-Package-Modul, SiP-Modul, umfassend:
ein Substrat (120);
einen Bildsensor (110), der auf einer Oberfläche des Substrats (120) angeordnet ist;
einen Serialisierer (130), der innerhalb des Substrats (120) eingebettet ist, und
ein Wärmeableitungspad (150), das in der anderen Oberfläche des Substrats (120) angeordnet ist,
wobei das Substrat (120) ein Durchgangsloch einschließt, das durch das Substrat (120) hindurchdringt, um den Bildsensor (110) und den Serialisierer (130) elektrisch zu verbinden,
wobei der Serialisierer (130) angeordnet ist, um mit dem Bildsensor (110) in einer optischen Achse zu überlappen,
wobei der Serialisierer (130) angeordnet ist, um mit dem Wärmeableitungspad (150) in Richtung der optischen Achse zu überlappen,
**dadurch gekennzeichnet, dass**
das Substrat (120) eine erste Schicht (121), auf der der Bildsensor (110) angeordnet ist, eine zweite Schicht (123), in der der Serialisierer (130) eingebettet ist, und eine dritte Schicht (122), auf der das Wärmeableitungspad (150) angeordnet ist, umfasst,
dass die zweite Schicht (123) zwischen der ersten Schicht (121) und der dritten Schicht (122) angeordnet ist,
dass die zweite Schicht (123) so geformt ist, dass der Serialisierer (130) darin eingebettet ist, und
dass ein Widerstand (140) innerhalb der zweiten Schicht (123) des Substrats (120) angrenzend an dem Serialisierer (130) eingebettet ist,
wobei elektronische Bauteile, die innerhalb oder auf einer Oberfläche des Substrats (120) montiert sind, mit dem Widerstand (140) verbunden sind, sodass sie innerhalb des Substrats (120) abgeschlossen werden können, und
dass ein erstes Klebeelement auf einer Oberfläche der zweiten Schicht (123) aufgebracht ist, um Luft in der zweiten Schicht (123), in der der Serialisierer (130) eingebettet ist, zu beseitigen, sodass eine thermische Ausdehnung nicht auftritt.

2. SiP-Modul nach Anspruch 1, umfassend: einen Höcker (160), der auf einer unteren Oberfläche des Bildsensors (110) ausgebildet ist, wobei der Höcker (160) an das Substrat (120) gebunden ist.

3. SiP-Modul nach Anspruch 2, wobei ein zweites Klebeelement (170) auf einem bestimmten Bereich aufgebracht ist, der zwischen dem Bildsensor (110) und dem Substrat (120) ausgebildet ist.

4. SiP-Modul nach Anspruch 1, wobei der Serialisierer (130) ein beliebiger unter Chipsätzen für Low-Voltage-Differential-Signaling (LVDS), V-by-One HS, HD-Base-T und MIPI A-PHY ist.

5. SiP-Modul nach Anspruch 1, wobei der Bildsensor (110) ein Bildsensor (110) unter einer Vielzahl von Arten von Bildsensoren (110) ist und wobei ein Pin an einer Position ausgebildet ist, die einem Verbindungsanschluss entspricht, der mit einer Pin-Belegung auf einer Oberfläche des Substrats (120) konfiguriert ist.

## Revendications

1. Un module SiP (System in Package), comprenant :
un substrat (120) ;
un capteur d'image (110) disposé sur une surface du substrat (120) ;
un sérialiseur (130) intégré à l'intérieur du substrat (120), et
une pastille de dissipation thermique (150) disposée sur l'autre surface du substrat (120),
dans lequel le substrat (120) comprend un trou d'interconnexion qui traverse le substrat (120) afin de connecter électriquement le capteur d'image (110) et le sérialiseur (130),
dans lequel le sérialiseur (130) est disposé de manière à se superposer au capteur d'image (110) selon l'axe optique,
dans lequel le sérialiseur (130) est disposé de manière à se superposer à la pastille de dissipation thermique (150) selon la direction de l'axe optique,
**caractérisé en ce que**
le substrat (120) comprend une première couche (121) sur laquelle est disposé le capteur d'image (110), une deuxième couche (123) dans laquelle est intégré le sérialiseur (130), et une troisième couche (122) sur laquelle est disposée la pastille de dissipation thermique (150),
et **en ce que** la deuxième couche (123) est disposée entre la première couche (121) et la troisième couche (122),
et **en ce que** la deuxième couche (123) est moulée de sorte que le sérialiseur (130) y soit intégré, et
**en ce qu'**une résistance (140) est intégrée à l'intérieur de la deuxième couche (123) du substrat (120), adjacente au sérialiseur (130),
dans lequel des composants électroniques montés à l'intérieur ou sur une surface du substrat (120) sont connectés à la résistance (140) de sorte qu'ils puissent être terminés à l'intérieur du substrat (120),
et
qu'un premier élément adhésif est appliqué sur une surface de la deuxième couche (123) afin d'éliminer l'air dans la deuxième couche (123) dans laquelle le sérialiseur (130) est intégré, de sorte qu'aucune dilatation thermique ne se produise.

2. Le module SiP selon la revendication 1, comprenant : un bossage (160) formé sur une surface inférieure du capteur d'image (110), dans lequel le bossage (160) est lié au substrat (120).

3. Le module SiP selon la revendication 2, dans lequel un deuxième élément adhésif (170) est appliqué dans un espace donné formé entre le capteur d'image (110) et le substrat (120).

4. Le module SiP selon la revendication 1, dans lequel le sérialiseur (130) est l'un quelconque parmi les jeux de puces LVDS (signalisation différentielle basse tension), V-by-One HS, HD-Base-T et MIPI A-PHY

5. Le module SiP selon la revendication 1, dans lequel le capteur d'image (110) est un capteur d'image (110) d'un type parmi plusieurs types de capteurs d'image (110), et dans lequel une broche est formée à une position correspondant à une borne de connexion configurée selon un brochage sur une surface du substrat (120).
